# EUROPÄISCHE PATENTSCHRIFT

(11) **EP 1 162 630 B1**
(45) Veröffentlichungstag und Bekanntmachung des Hinweises auf die Patenterteilung: **13.10.2004**
(21) Anmeldenummer: 01890162.9
(22) Anmeldetag: 28.05.2001
(51) Int. Cl.: H01B 7/08

(54) **Flachbandkabel**
Flat ribbon cable
Câble-ruban plat

(30) Priorität: 08.06.2000 EP 00890188; 01.09.2000 EP 00890268
(43) Veröffentlichungstag der Anmeldung: 12.12.2001
(73) Patentinhaber: I & T Innovation Technik Vertriebs-Ges.m.b.H., 7000 Eisenstadt (AT)
(72) Erfinder: Adams, Winfried, 71067 Sindelfingen (DE); Schubert, Artur, 2803 Schwarzenbach (AT)
(74) Vertreter: Patentanwälte BARGER, PISO & PARTNER

(56) Entgegenhaltungen:
- DE-A- 2 424 442

## Beschreibung

Die Erfindung betrifft ein laminiertes oder extrudiertes Flachbandkabel, auch elektrischer Flachleiter genannt, gemäß dem einleitenden Teil des Anspruches 1.

Sogenannte laminierte Flachbandkabel bestehen im wesentlichen aus einer flexiblen, elektrisch nicht leitenden Trägerfolie, auf der Leiterbahnen vorgesehen sind, die einen im wesentlichen rechteckigen Querschnitt aufweisen und daher oft auch Rechteckleiter genannt werden. Diese Leiterbahnen sind voneinander isoliert, d.h. im Abstand voneinander angeordnet und werden durch eine gemeinsame Abdeckfolie, die, mit Hilfe passender Klebstoffe, auf die Trägerfolie und die Leiterbahnen laminiert wurde, abgedeckt.

Die sogenannten extrudierten Flachbandkabel bestehen aus im wesentlichen in einer Ebene parallel zueinander verlaufenden, Abstand voneinander aufweisenden Leiterbahnen, die mittels einer elektrisch nicht leitenden Masse durch ein Extrusionsverfahren umhüllt worden sind.

Für die Erfindung sind beide Arten von Flachbandkabeln völlig gleichwertig, sie werden in der Automobilindustrie zunehmend eingesetzt, da sie gegenüber den aus einzelnen Rundkabeln bestehenden Kabelbäumen verschiedene Vorteile beim Handling und bei der Unterbringung anstellen, mit extrem geringer freier Bauhöhe große Vorteile aufweisen.

Nachteilig bei diesen Flachbandkabeln ist, daß zufolge der unterschiedlichen Dimensionierung der einzelnen Leiterbahnen in Abhängigkeit von der von ihnen zu ertragenden Stromstärke, die Kontaktierung kompliziert ist und daß es insbesondere problematisch ist, Verbindungen zu Platinen von Steuergeräten, Stromverbrauchern oder Sensoren, aber auch zu Rundkabeln, wie sie beispielsweise in üblichen Kabelbäumen verwendet werden, zu schaffen. Es ist die Aufgabe der Erfindung, hier eine Lösung anzubieten, die die Kontaktierung derartiger Flachbandkabel vereinfacht.

Erfindungsgemäß ist dazu vorgesehen, bei einem Flachbandkabel gemäß dem einleitenden Teil des Anspruches 1 die Merkmale des kennzeichnenden Teiles des Anspruches 1 zu verwirklichen, nämlich die Breiten der Leiterbahnen in einer arithmetischen Folge zu staffeln, die Abstände zwischen benachbarten Leiterbahnen immer gleich groß oder ebenfalls in einer arithmetischen Folge mit gleicher Differenz wie die Breite der Leiterbahnen gestaffelt zu halten und bevorzugt die Kontaktierung der Leiterbahnen unabhängig von ihrer Breite mittels Steckern, beispielsweise Klemmleisten, durchzuführen, deren Kontakte äquidistant zueinander im Abstand der Breite der schmälsten Leiterbahn, vermehrt um den Grundabstand zwischen benachbarten Leiterbahnen, vorgesehen sind.

Auf diese Weise ist es möglich, schwach belastete und daher schmale Leiterbahnen so anzuordnen und auszubilden, daß sie am Ende des Flachleiters bei dichtester Anordnung so liegen, daß jede dieser Leiterbahnen von einem Kontakt der Klemmleiste erfaßt wird. Die nächstbreitere Leiterbahn wird von zwei Kontakten der Klemmleiste erfaßt, die nächstbreitere von drei usw. usw. Damit erhält man trotz Verwendung einheitlicher Stecker eine an die jeweilige Strombelastung angepaßte Kontaktierung der einzelnen Leiterbahnen. Wenn die Abstände zwischen benachbarten Leiterbahnen nicht dem Grundabstand entsprechen, so sind sie nach einem Raster auszuwählen, der vom Grundabstand ausgeht und zu dem ein ganzzahliges Vielfaches des gleichen Rasterabstandes wie bei den Leiterbahnen gezählt wird. Dadurch bleibt der Vorteil der richtigen Kontaktierung bei äquidistanter Anordnung der Kontakte des Steckers immer erhalten.

Dies ermöglicht auch einen einfachen Übergang auf andere Flachkabel oder auf Rundkabel, da dazu nur die einzelnen Kontakte (Pins) des Steckers mit entsprechenden Drähten eines Rundkabels verbunden sein müssen und auf Platinen oder Gerätesockel, auf die der Stecker direkt aufgesetzt werden kann.

Selbstverständlich ist es möglich, zusätzlich zu dieser Breitenstaffelung eine Dickenstaffelung der Leiterbahnen vorzusehen, die aber bevorzugt nicht innerhalb eines Flachbandkabels erfolgt, sodaß bei einem Flachbandkabel nur Leiterbahnen einer Stärke, aber gegebenenfalls unterschiedlicher Breite vorgesehen sind.

In einer Ausgestaltung der Erfindung ist vorgesehen, als Rastermaß 2,54 mm (0,1 Zoll) zu wählen und als Abstand zwischen benachbarten Leiterplatten einen Millimeter zur Schaffung elektrischer Isolierung zu wählen, sodaß die schmälste Leiterbahn eine Breite von 1,54 mm aufweist, die nächste von 2 x 2,54 - 1 mm, die nächste von 3 x 2,54 -1 mm, etc.. Analog dazu beträgt der Grundabstand zwischen benachbarten Leiterbahnen 1 mm, der nächste 2,54 + 1 mm, der nächste 2 x 2,54 + 1 mm, der nächste 3 x 2,54 + 1 mm, etc.. Dies ermöglicht eine besonders einfache Anbindung an die zumeist verwendeten PCB-Platinen, wie sie insbesondere im Automobilbau, aber auch sonst in der Elektronik zumeist verwendet werden.

Die Erfindung bietet den weiteren Vorteil, daß es durch sie möglich wird, die verwendeten Stecker als Endlosprodukte herzustellen, die zur Verwendung nur mehr an die Breite der jeweils zu kontaktierenden Flachbandkabel angepaßt werden müssen. Die Vielzahl der bisher notwendigen Stecker entfällt somit vollständig, es ist gegebenenfalls nur notwendig, für die unterschiedlich dicken Leiterbahnen unterschiedlich hohe Stecker vorzusehen, die aber beispielsweise durch farbliche Markierung leicht auseinanderzuhalten sind und keinen großen logistischen Aufwand erfordern.

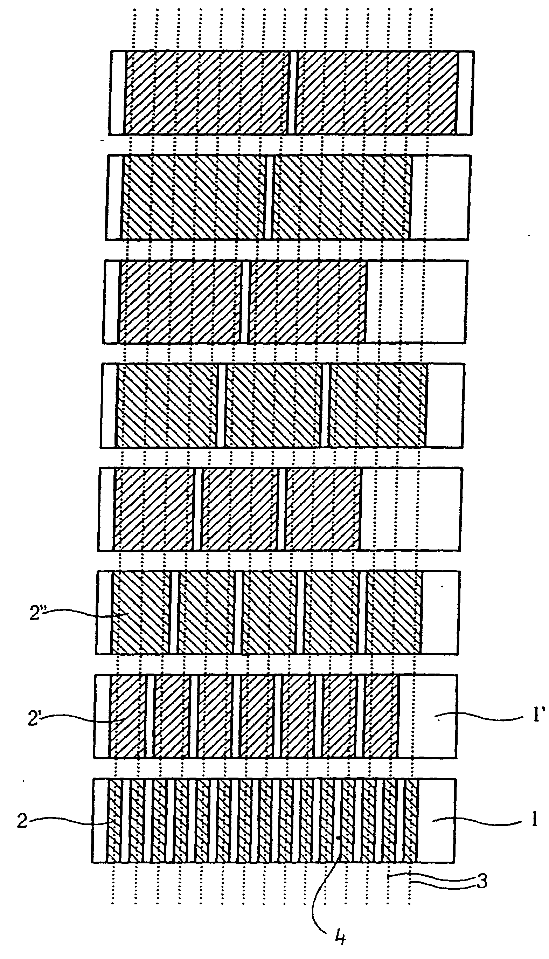

Die Erfindung wird im folgenden anhand der Zeichnung näher erläutert. Die einzige Figur zeigt verschiedene Aufteilungsmöglichkeiten, wobei beim dargestellten Beispiel in jedem der gezeigten Abschnitte der verschiedenen Flachbandkabel 1, 1', etc. immer nur Leiterbahnen 2, 2', 2" einer Breite vorgesehen sind. Dies ist selbstverständlich nicht notwendig, es können in einem Flachbandkabel auch Leiterbahnen unterschiedlicher Breite vorgesehen sein.

Wie aus der Figur hervorgeht, ist es mit äquidistant angeordneten Kontakten eines Steckers oder eines anderen Anschlusses, symbolisiert durch die strichlierten, äquidistanten Linien 3 möglich, die breiten Leiterbahnen 2" öfter zu kontaktieren als die schmalen 2' bzw. 2, sodaß ein entsprechend stärkerer Strom sowohl in der Leiterbahn als auch im Anschluß geleitet bzw. übertragen werden kann, ohne auf die Vorteile eines einheitlichen Maßes der Flachbandkabel oder äquidistanter, untereinander identischer Kontakte beim Stecker verzichten zu müssen.

Die Dicke der einzelnen Leiterbahnen ermöglicht eine weitere Anpassung an die zu leitende Stromstärke, wie aus nachfolgender Tabelle ersichtlich ist, ist es damit möglich, einen großen Bereich an Leiterquerschnitten abzudecken. Es ist dabei auch möglich, Leiterbahnen unterschiedlicher Stärke in einem Flachbandkabel vorzusehen, wenn auch bei großen Unterschieden in der Dicke das Handling des Endlosmaterials möglicherweise problematisch wird.

**Tabelle**

| Rasteranzahl | Breite | Querschnitt bei einer Dicke d von | | | |
|---|---|---|---|---|---|
| | | d=0,15 | d=0,2 | d=0,2273 | d=0,25 |
| 8 | 19,32 | 2,90 | 3,86 | 4,32 | 4,83 |
| 7 | 16,78 | 2,52 | 3,36 | 3,81 | 4,20 |
| 6 | 14,24 | 2,14 | 2,85 | 3,24 | 3,56 |
| 5 | 11,7 | 1,76 | 2,34 | 2,66 | 2,93 |
| 4 | 9,16 | 1,37 | 1,83 | 2,08 | 2,29 |
| 3 | 6,62 | 0,99 | 1,32 | 1,50 | 1,66 |
| 2 | 4,08 | 0,61 | 0,82 | 0,93 | 1,02 |
| 1 | 1,54 | 0,23 | 0,31 | 0,35 | 0,39 |

Die Erfindung ist selbstverständlich nicht auf die beschriebene und dargestellte Ausfiihrungsform beschränkt sondern kann verschiedentlich abgewandelt und verändert werden. So ist es bei laminierten Flachkabeln möglich, mehr als eine Träger- bzw. Abdeckfolie zu verwenden und die in der Beschreibung genannten Abmessungen anders zu wählen. Die genannten absoluten Abmessungen sind nur wegen ihrer direkten Kompatibilität mit den handelsüblichen Platinen bevorzugt.

Üblicherweise wird man schon aus Platz- und Kostengründen versuchen, jeweils mit dem Grundabstand zwischen benachbarten Leiterbahnen auszukommen, doch wenn dies nicht möglich oder erwünscht ist, so ist durch die angegebene Staffelung das Erfindungsziel ebenso zu erreichen.

Als Materialien für die erfindungsgemäßen Flachbandkabel können alle Materialien eingesetzt werden, die auch bei herkömmlichen Flachbandkabeln, seien sie laminiert oder extrudiert, verwendet werden.

## Patentansprüche

1. Laminierte oder extrudierte Flachbandkabel, auch elektrischer Flachleiter genannt, bestehend aus im wesentlichen in eine Ebene parallel zweinander verlaufenden und voreinander isolierten Leiterbahnen mit in wesentlichen rechteckigem Querschnitt, **dadurch gekennzeichnet, daß** die Breiten der Leiterbahnen (2,2',2") in einer arithmetischen Folge gestaffelt sind und daß die Abstände (4) zwischen benachbarten Leiterbahnen bevorzugt gleich groß oder ebenfalls in einer arithmetischen Folge gestaffelt sind.

2. Flachbandkabel nach Anspruch 1, **dadurch gekennzeichnet, daß** die Kontaktierung der Leiterbahnen (2,2',2") unabhängig von ihrer Breite mittels Steckern, beispielsweise Klemmleisten, erfolgt, deren Kontakte äquidistant zueinander im Abstand der Breite der schmälsten Leiterbahn, vermehrt um den Grundabstand zwischen den Leiterbahnen, vorgesehen sind.

3. Flachbandkabel nach Anspruch 1 oder 2, **dadurch gekennzeichnet, daß** die Breite der Schmälsten Leiterbahn 1,54 mm beträgt und sich die Breiten aus Leiterbahnen um ein ganzzahliges Vielfaches von 2,54 mm unterscheiden und daß der Abstand zwischen benachbarten Leiterbahnen 1 mm bzw. 1 mm plus ein ganzzahliges Vielfaches von 2,54 mm beträgt.

## Claims

1. Laminated or extruded flat ribbon cable, also known as a flat electrical conductor, comprising conductor tracks extending substantially in a plane parallel to one another and insulated from one another, of a substantially rectangular cross section, **characterized in that** the widths of the conductor tracks (2, 2', 2'') are staggered in an arithmetic sequence and **in that** the spacings (4) between adjacent conductor tracks are preferably of the same size or likewise staggered in an arithmetic sequence.

2. Flat ribbon cable according to Claim 1, **characterized in that** contacting of the conductor tracks (2, 2', 2'') takes place independently of their width by means of connectors, for example terminal strips, the contacts of which are provided equidistant from one another at a distance equal to the width of the narrowest conductor track, multiplied by the basic spacing between the conductor tracks.

3. Flat ribbon cable according to Claim 1 or 2, **characterized in that** the width of the narrowest conductor track is 1.54 mm and the widths of the conductor tracks differ by an integral multiple of 2.54 mm and **in that** the spacing between adjacent conductor tracks is 1 mm or 1 mm plus an integral multiple of 2.54 mm.

## Revendications

1. Câble-ruban plat laminé ou extrudé, également nommé conducteur plat électrique, constitué de rubans conducteurs présentant une section sensiblement carrée, isolés les uns des autres et s'étendant sensiblement parallèlement les uns aux autres dans un plan, **caractérisé en ce que** les largeurs des rubans conducteurs (2, 2', 2'') sont échelonnées selon un ordre arithmétique et **en ce que** les distances (4) entre des rubans conducteurs voisins sont échelonnées de préférence selon la même dimension ou également selon un ordre arithmétique.

2. Câble-ruban plat selon la revendication 1, **caractérisé en ce que** l'établissement d'un contact entre les rubans conducteurs (2, 2', 2") se fait indépendamment de leur largeur au moyen de connecteurs, par exemple de bornes plates, dont les contacts sont prévus à équidistance les uns des autres à distance de la largeur du ruban conducteur le plus étroit, augmenté de la distance de base entre les rubans conducteurs.

3. Câble-ruban plat selon la revendication 1 ou 2, **caractérisé en ce que** la largeur du ruban conducteur le plus étroit s'élève à 1,54 mm et les largeurs des rubans conducteurs différent d'un multiple entier de 2,54 mm et **en ce que** la distance entre des rubans conducteurs voisins s'élève à 1 mm ou à 1 mm plus un multiple entier de 2,54 mm.
